# FASCICULE DE BREVET EUROPEEN

(11) **EP 0 424 256 B1**
(45) Date de publication et mention de la délivrance du brevet: **19.04.1995**
(21) Numéro de dépôt: 90402917.0
(22) Date de dépôt: 17.10.1990
(51) Int. Cl.: H01J 37/32

(54) **Dispositif de traitement chimique assisté par un plasma de diffusion**
Gerät für chemische Behandlung mit Hilfe eines Diffusionsplasmas
Device for chemical treatment assisted by a diffusion plasma

(30) Priorité: 19.10.1989 FR 8913685
(43) Date de publication de la demande: 24.04.1991
(73) Titulaire: COMMISSARIAT A L'ENERGIE ATOMIQUE, 75015 Paris (FR)
(72) Inventeur: Charlet, Barbara, F-38330 Montbonnot (FR); Peccoud, Louise, F-38640 Claix (FR); Sindzingre, Thierry, F-94230 Cachan (FR)
(74) Mandataire: Dubois-Chabert, Guy

(56) Documents cités:
- EP-A- 0 090 586
- EP-A- 0 237 078
- US-A- 4 401 054
- MICROELECTRONIC ENGINEERING, vol. 3, no. 1/4, décembre 1985, AMSTERDAM NL, pages 397-410; J Paraszczak et al.: "Methods of creation and effect of microwave plasmas upon the etching of polymers and silicon"

## Description

L'invention se rapporte à un dispositif de traitement chimique assisté par un plasma de diffusion et plus spécialement à un dispositif de dépôt chimique et de gravure chimique en phase vapeur assistés par un plasma de diffusion.

Elle s'applique en particulier dans le domaine de la microélectronique pour la fabrication des circuits intégrés et des lasers à semi-conducteur et dans le domaine de l'optique intégrée.

Il est connu dans le domaine du dépôt chimique assisté par un plasma d'utiliser une enceinte à vide contenant un récepteur ou support destiné à supporter un ou plusieurs substrats à la fois. Un mélange gazeux contenant entre autre des formes gazeuses des atomes que l'on doit déposer sur le substrat est introduit au voisinage du récepteur. L'écoulement gazeux déterminé par la forme et les dimensions de l'enceinte et du récepteur est généralement contraint à s'écouler parallèlement aux substrats.

Grâce à une interaction entre le plasma et le substrat, maintenu à une température adéquate, la couche désirée se dépose et adhère à la surface du substrat.

L'utilisation d'un plasma permet d'abaisser la température des dépôts à une température inférieure à 600°C, ce qui est obligatoire pour certains dépôts en microélectronique.

Cette technique de dépôt était jusqu'à présent satisfaisante mais en raison des tailles de plus en plus grandes des substrats à traiter et des exigences de qualité de plus en plus poussées pour ces dépôts, les limites de cette technique sont désormais atteintes.

Le problème à résoudre est un problème d'écoulement gazeux pour les dépôts chimiques en phase vapeur, auquel s'ajoutent les contraintes liées à l'utilisation d'un plasma.

En particulier, il faut empêcher la diminution des réactifs sur le trajet des surfaces parcourues pour lutter contre la croissance non-uniforme des couches déposées. De plus, il faut limiter la contamination des substrats. En effet, les parois de l'enceinte à vide se couvrent de dépôts indésirables qui deviennent autant de sources de particules pouvant s'incorporer au matériau en cours de dépôt.

Le plasma utilisé pour l'assistance peut être localisé à partir d'un plasma de type planaire ou de diffusion.

Par rapport aux plasmas localisés, les plasmas de diffusion ont l'avantage de séparer la zone de création du plasma de la zone d'utilisation des espèces ionisées. Il est ainsi possible d'assurer le contrôle de l'énergie de bombardement des espèces ioniques sur le substrat et de diminuer les défauts induits par le plasma dans les dépôts. Par ailleurs, le chauffage du substrat peut également être diminué.

Pour obtenir un dépôt de bonne qualité et pour mieux localiser ce dépôt sur le substrat, il est souvent préférable d'utiliser deux gaz dont l'un au moins est réactif et de n'ioniser qu'un seul de ces gaz. Ensuite, il est impératif de mélanger de manière homogène ces gaz qui se trouveront en contact avec les substrats à traiter.

Les dispositifs connus de dépôt du type monoplaquette posent deux problèmes essentiels à résoudre simultanément, la vitesse de dépôt et son uniformité. Aussi, l'insertion de ces machines de dépôt dans les lignes de production ne peut se faire que si ces machines sont compatibles avec les cadences de production.

L'uniformité des dépôts sur toute la surface du substrat est nécessaire pour obtenir des matériaux satisfaisant aux qualités requises. Cette uniformité est pilotée par la diffusion en volume d'un gaz dans l'autre et par la diffusion à la surface du substrat des espèces réactives, diffusions de surface qui dépend de la température du substrat. Or, dans certains cas, cette température ne doit pas être trop élevée (<600°C).

Aussi, l'uniformité des dépôts se trouve dans l'uniformisation en volume du mélange de gaz.

L'uniformité des dépôts est facile à obtenir lorsque l'on travaille à très basse pression (< 0,13 Pa), et donc à des concentrations faibles en espèces chimiques. Dans ces conditions, la vitesse de dépôt est fonction des capacités de pompage de l'enceinte à vide ; le débit de gaz pompé doit être élevé pour avoir des vitesses de dépôt élevées.

A haute pression (>130 Pa), les concentrations des espèces réactives sont importantes et conduisent à des vitesses de dépôt élevées (>5 »m/min). Cependant, on favorise dans ce cas une réaction entre les gaz présents (appelée nucléation), nuisible pour l'homogénéité et l'adhérence du dépôt car celui-ci s'effectue sous forme de poudre. De plus, la diffusion en volume étant faible, l'uniformité du dépôt sera difficile à obtenir.

A moyenne pression, l'obtention de grande vitesse de dépôt est fonction du pompage du milieu gazeux de l'enceinte et d'une forte dissociation de ce milieu gazeux. L'uniformité du dépôt est intermédiaire entre les deux cas précédents.

Le plus souvent, l'un des gaz est utilisé comme gaz porteur. Son débit est donc beaucoup plus important que les autres, ce qui rend l'homogénéisation du milieu gazeux très difficile dans la gamme des moyennes pressions avec des écoulements de gaz de l'ordre de quelques m/s.

L'uniformité des dépôts et leur vitesse passent donc par l'uniformisation en volume du ou des gaz réactifs et du gaz porteur.

Un dispositif de dépôt chimique en phase vapeur (CVD) assisté par un plasma de diffusion est décrit dans l'article de M.M. MOSLEHI, IEEE Electron Device Letters, vol. EDL.8, n°9 de septembre 1987, "Formation of MOS gates by rapid thermal/microwave remote-plasma multiprocessing", p. 421-424.

Dans ce dispositif le gaz réactif est non ionisé et introduit parallèlement au substrat. De plus, le pompage de l'enceinte de dépôt est assuré parallèlement au substrat.

L'écoulement des gaz parallèlement au substrat et la distribution du gaz porteur ionisé particulière dans ce dispositif de dépôt ne peuvent pas conduire à un dépôt homogène. De plus, aucun système n'y est prévu pour uniformiser en volume le milieu gazeux de l'enceinte.

Un autre dispositif de dépôt CVD assisté par un plasma de diffusion est décrit dans l'article de G. LUCOVSKY et D.V. TSU, Journal of Non-Crystalline Solids 90(1987), p.259-266 "Deposition of silicon oxide, nitride and oxynitride thin films by remote plasma enhanced chemical vapor deposition".

Dans le dispositif de G. LUCOVSKY, le gaz réactif est diffusé à la périphérie de l'enceinte de dépôt grâce à un anneau de diffusion entraînant des inhomogénéités dans le dépôt. En outre, ce dispositif ne peut être utilisé que pour des substrats de petites dimensions. Par ailleurs, le plasma y est peu dissocié du fait de l'utilisation de fréquences radio.

Dans le document FR-A-2 588 275, il est prévu un dispositif de dépôt CVD comportant un diffuseur des gaz réactifs, agencé de façon à uniformiser les dépôts. A cet effet, ce diffuseur est constitué d'une plaque perforée disposée au-dessus du substrat et parallèlement à celui-ci. De plus, cette plaque est orientée perpendiculairement à l'axe de l'enceinte.

Malheureusement, ce dispositif ne peut pas être utilisé pour une assistance par plasma de diffusion. En effet, ce dispositif comporte des chicanes au niveau du diffuseur dont la forme conduirait à une désexcitation du plasma et donc à l'obtention d'un gaz neutre ne pouvant plus agir avec le gaz réactif.

L'invention a justement pour objet un dispositif de dépôt chimique en phase vapeur assisté par un plasma de diffusion conduisant à des dépôts homogènes sur des substrats de grandes dimensions.

Par ailleurs, dans les procédés de gravures chimiques sèches, on utilise souvent une assistance par plasma pour obtenir des gravures anisotropes conduisant à des profils abrupts et à des fonds de gravure plans et lisses.

L'anisotropie de la gravure et l'homogénéité de celle-ci, sur des substrats de grandes tailles, dépendent aussi de l'uniformisation en volume du mélange de gaz et les problèmes exposés précédemment pour les dépôts CVD s'appliquent aussi aux gravures chimiques assistées par un plasma.

En effet, la différence essentielle entre les dépôts CVD et les gravures chimiques sèches réside dans la nature des gaz réactifs. Aussi, un dispositif de dépôt CVD peut aussi être utilisé pour de la gravure chimique sèche.

L'invention a donc pour objet un dispositif de traitement chimique assisté par un plasma de diffusion permettant de remédier aux inconvénients ci-dessus. Ce dispositif assure en particulier des dépôts et des gravures homogènes pour des substrats de grandes tailles (supérieure à 3 cm de diamètre et même supérieure à 15 cm de diamètre) avec des vitesses compatibles avec les cadences de production. Par ailleurs, les dépôts effectués sont très peu contaminés.

De plus, ce dispositif permet un contrôle de l'énergie de bombardement ionique des substrats diminuant ainsi les défauts induits par le plasma dans les dépôts et matériaux gravés.

Enfin, ce dispositif peut être du type monosubstrat ou multisubstrat.

Les moyens d'homogénéisation des gaz utilisés dans le dispositif de traitement de l'invention résultent de toute une série d'expériences effectuées par les inventeurs. Ces expériences ont permis de montrer que le gaz réactif non ionisé devait avoir une distribution délocalisée dans le gaz porteur ionisé, une distribution ponctuelle ou une distribution périphérique du gaz non ionisé conduisant toujours à des dépôts non uniformes ; la distribution ponctuelle conduisait à un dépôt ayant la forme d'une gaussienne et la distribution périphérique à un dépôt ayant la forme de deux gaussiennes successives, les maximums de ces gaussiennes étant situés en regard de l'injecteur du gaz non ionisé dans l'enceinte.

De façon plus précise, l'invention a pour objet un dispositif de traitement chimique assisté par un plasma de diffusion comportant :
- une enceinte étanche de traitement comportant un axe de symétrie,
- des moyens de production axiale d'un plasma d'un gaz porteur dans l'enceinte,
- au moins une plaque pleine servant d'obstacle au plasma, disposée perpendiculairement à l'axe et en aval des moyens de production,
- des moyens de diffusion du plasma, disposés dans l'enceinte en aval de la plaque,
- plusieurs tubes d'alimentation en gaz vecteur non ionisé débouchant axialement dans l'enceinte, sous les moyens de diffusion, les extrémités de ces tubes débouchant dans l'enceinte étant situées dans un même plan tout autour de l'axe de l'enceinte,
- au moins un porte-substrat disposé dans l'enceinte en aval des tubes d'alimentation et perpendiculairement à l'axe de l'enceinte,
- des moyens de pompage annulaire et axial du milieu gazeux contenu dans l'enceinte, disposés en aval du porte-substrat.

Le gaz porteur et le gaz vecteur peuvent être constitués respectivement d'un seul gaz ou d'un mélange gazeux, la composition de ces gaz étant fonction du type de dépôt ou de la gravure envisagé.

Par ailleurs, le gaz porteur peut être un gaz inerte ne participant pas au dépôt ou à la gravure, ou un gaz réactif. Par exemple, pour un dépôt de silicium, le gaz porteur est de l'hydrogène et le gaz vecteur un silane ou un disilane tel que SiH₄, SiH₂Cl₂, Si₂H₆, ... et pour un dépôt de SiO₂ le gaz porteur est du N₂O et le gaz vecteur un silane.

Le dispositif de l'invention permet une distribution de gaz limitant spatialement la formation des dépôts ou gravures à la zone de mélange des gaz.

Grâce au dispositif de l'invention, la répartition du gaz vecteur non ionisé dans le flux du gaz porteur ionisé lui assure un champ de pression partielle uniforme, limitant les risques locaux de nucléation en phase homogène. Ainsi, les risques de pollution particulaire des dépôts ou gravures se trouvent diminués. En outre, le rendement des gaz réactifs est augmenté et de grandes vitesses de dépôt et de gravure peuvent être atteintes (par exemple 5 »m/min) en utilisant de gros débits de gaz réactifs et de pompage (débit de gaz de l'ordre de 500 scc/min, débit de pompage de l'ordre de 10000 l/min).

Dans le cas d'un dépôt, la stoechiométrie de celui-ci est controlée par la composition du mélange gazeux et est ajustée par les valeurs relatives des débits gazeux.

De préférence, le dispositif comprend, de plus, une chambre tampon fermée par une plaque perforée constituant les moyens de diffusion du plasma, cette chambre communiquant avec les moyens de production du plasma, la plaque obstacle contenue dans cette chambre définissant avec cette dernière un espace périphérique pour l'écoulement du plasma. Ceci permet de bien séparer la zone de création du plasma du substrat et donc de découpler les moyens de production du plasma de la dimension des substrats. Ainsi, le dispositif de l'invention permet de traiter des substrats de grandes dimensions, de 15 cm à 20 cm (6 ou 8 pouces) de diamètre.

Selon un mode de réalisation préféré de l'invention, le dispositif comprend en outre une chambre tampon périphérique, entourant l'axe de l'enceinte et communiquant avec les tubes d'alimentation en gaz vecteur et des moyens d'alimentation en gaz vecteur de cette chambre tampon.

De façon avantageuse, ces tubes sont réalisés en un matériau conducteur de l'électricité et sont polarisés à l'aide d'une tension radio-fréquence ou basse fréquence. Ce système permet d'obtenir des plasmas locaux générant des espèces actives de natures différentes qui réagissent avec celles issues des moyens de production du plasma supérieurs. En outre, ceci permet d'éviter des dépôts sur les tubes d'alimentation en gaz et donc un encrassement de ceux-ci.

Avantageusement, une polarisation RF ou basse fréquence peut être maintenue sur le porte-substrat pour assurer le contrôle de l'énergie des ions incidents et donc la stoechiométrie du dépôt, ses contraintes et sa densité et dans le cas de la gravure, son anisotropie et sa sélectivité.

D'autres caractéristiques et avantages de l'invention ressortiront mieux de la description qui va suivre, donnée à titre illustratif et non limitatif, en référence aux dessins annexés, dans lesquels :
- la figure 1 représente schématiquement le principe du dispositif de traitement conforme à l'invention,
- la figure 2 représente une perspective écorchée d'un mode de réalisation du dispositif conforme à l'invention,
- la figure 3 représente différentes formes d'usinage des perforations du diffuseur de gaz porteur ionisé du dispositif de la figure 2,
- la figure 4 représente schématiquement une partie agrandie de la figure 2 au niveau de la chambre tampon assurant l'alimentation en gaz vecteur,
- la figure 5 représente schématiquement une variante de réalisation des tubes d'alimentation en gaz vecteur du dispositif de l'invention, et
- les figures 6A et 6B représentent schématiquement et respectivement en vue de dessus et de dessous la répartition des extrémités des tubes d'alimentation.

La description ci-après se rapporte à une enceinte de traitement monosubstrat ; les modifications à apporter à ce dispositif pour en faire un dispositif multisubstrat sont à la portée de l'homme de l'art.

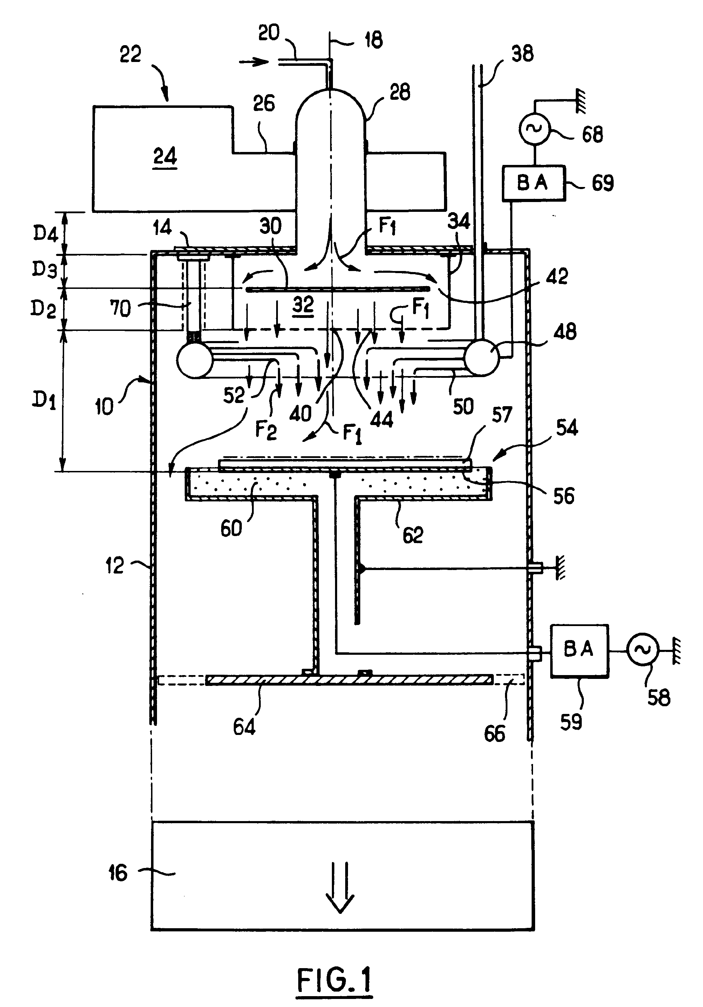

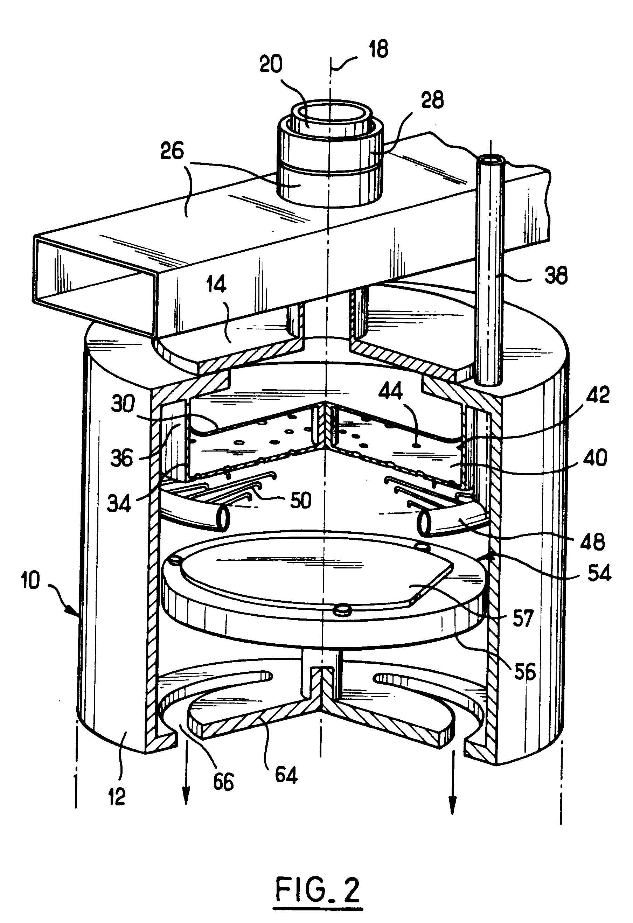

En se référant aux figures 1 et 2, le dispositif de traitement conforme à l'invention comporte une enceinte étanche de traitement 10, constituée d'une enveloppe cylindrique 12 fermée à son extrémité supérieure par un couvercle 14, l'autre extrémité de l'enveloppe étant en communication avec un système de pompage 16. L'axe de révolution de l'enceinte de traitement 10 porte la référence 18.

Sur le couvercle 14 de l'enceinte est monté un tube 20 d'alimentation en gaz porteur, dont l'axe de révolution est confondu avec l'axe 18 de l'enceinte. Ce tube axial 20 est couplé à une source d'excitation 22 du type surfaguide.

Ce type de source à plasma permet une forte dissociation du gaz porteur ; elle comprend un générateur d'ondes hyperfréquences 24 couplé par un guide d'ondes 26 de section rectangulaire à une cellule 28 à section circulaire, transparente aux ondes hyperfréquences et disposée selon l'axe 18 de l'enceinte. Cette cellule 28 est en communication directe avec le tube d'alimentation 20 en gaz porteur.

Les écoulements du gaz porteur issu de la cellule hyperfréquence 28, symbolisés par les flèches F1, sont perturbés par une plaque pleine 30 ayant la forme d'un disque plan. Cette plaque obstacle 30 est perpendiculaire à l'axe 18 et est logé dans une chambre tampon 32 de forme cylindrique. La plaque obstacle 30 est destinée en particulier à découpler la structure excitatrice du plasma du système d'injection dudit plasma dans l'enceinte 10.

L'enveloppe cylindrique 34 délimitant la chambre tampon 32 est solidaire du couvercle 14 de l'enceinte de traitement et son axe de révolution est confondu avec celui de l'enceinte. Cette enveloppe cylindrique 34 définit avec l'enveloppe 12 un espace annulaire 36 destiné au passage d'une conduite 38 d'alimentation périphérique en gaz vecteur non ionisé.

L'extrémité inférieure de la chambre 32 est fermée par une plaque perforée 40 de forme circulaire, solidaire de l'enveloppe cylindrique 34 et parallèle à la plaque obstacle 30. Cette plaque perforée jouant le rôle d'injecteur du plasma dans l'enceinte 10 permet la diffusion du plasma issu de la cellule 28 et perturbé par la plaque 30. Un espace annulaire 42 entre la plaque obstacle 30 et l'enveloppe cylindrique 34 assure le passage (F1) du plasma de gaz porteur de la cellule 28 vers la plaque de diffusion 40.

La forme des trous 44 de la plaque de diffusion 40 est ajustée selon les dimensions des substrats à traiter. Il en est de même pour leur nombre.

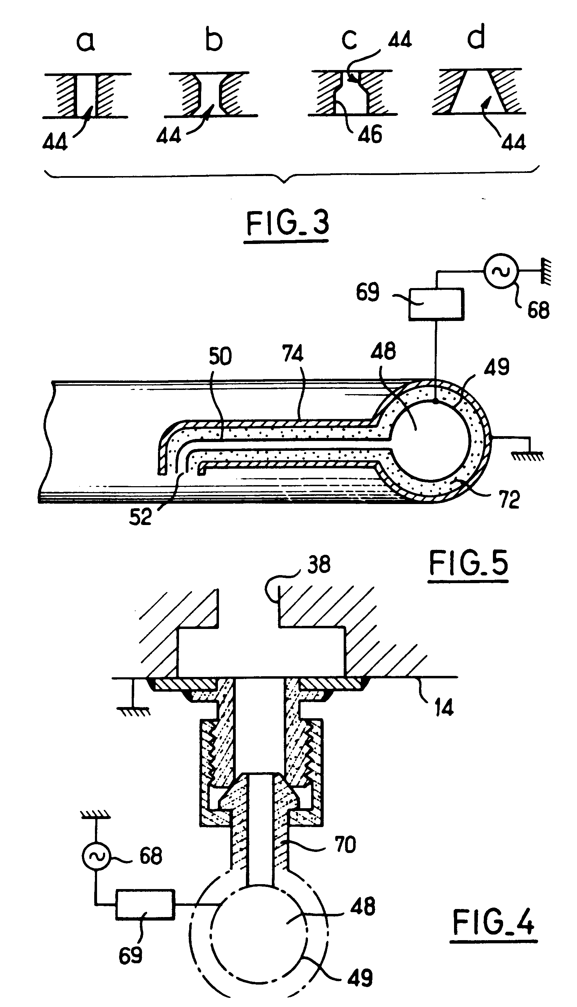

Sur la figure 3, on a représenté différentes formes possibles d'usinage des trous 44. Comme représenté sur cette figure, les trous 44 peuvent avoir une forme cylindrique (partie a de la figure 3), une forme en diabolo (partie b de la figure 3), une forme conique (partie d de la figure 3) ou présenter une forme générale cylindrique avec une section élargie 46 du côté de la sortie du plasma diffusé (partie C de la figure 3).

Comme pour les trous de la plaque de diffusion 40, les dimensions de la plaque obstacle 30 et celles de la chambre tampon 32 sont à adapter aux dimensions des substrats à traiter.

Plus les substrats à traiter seront grands, plus le volume de la chambre 32, la surface de la plaque 30 et le nombre de trous 44 du diffuseur seront élevés.

Afin d'assurer une bonne diffusion du gaz porteur ionisé, les trous 44 peuvent être répartis selon des cercles concentriques centrés sur l'axe 18. Ces cercles concentriques sont répartis en particulier selon un pas régulier.

En aval du diffuseur de plasma 40, on trouve une autre chambre tampon 48, de forme torique, en communication avec le tube d'alimentation 38 en gaz vecteur. Cette chambre périphérique 48 est délimitée par une enveloppe torique 49, centrée sur l'axe 18.

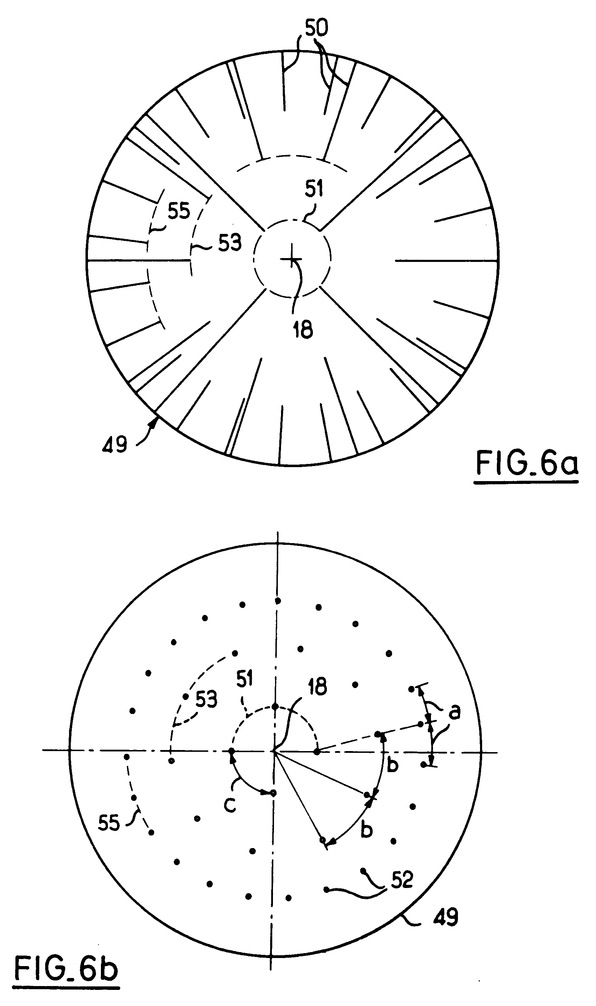

Cette chambre 48 est en communication avec plusieurs tubes 50 d'alimentation en gaz vecteur, débouchant axialement dans l'enceinte de traitement 10. Ces tubes 50 sont disposés radialement dans un même plan, parallèles à la plaque de diffusion 40 (et donc perpendiculaires à l'axe 18). Les extrémités 52 de ces tubes 50, débouchant dans l'enceinte 10, sont orientées vers un ensemble porte-substrat 54. Elles sont disposées dans un même plan et selon des cercles concentriques, centrés sur l'axe 18, comme représenté sur les figures 6A et 6B respectivement en vues de dessus et de dessous.

Sur ces figures 6A et 6B, on a représenté trois cercles concentriques 51, 53 et 55.

Les extrémités 52 d'un même cercle sont équidistantes les unes des autres ; les distances des extrémités des tubes disposées sur les cercles 51, 53 et 55 sont notées respectivement a, b et c. En outre, les extrémités des tubes d'un cercle concentrique donné, par exemple 53, sont disposées en quinconce par rapport aux extrémités des tubes situées sur les cercles concentriques adjacents 51 et 55.

Ces tubes 50 assurent une alimentation délocalisée du gaz vecteur non ionisé, sous le plan d'injection du plasma diffusé par le diffuseur 40. Les flèches F2 symbolisent la circulation du gaz vecteur.

En aval de ces tubes 50, on trouve l'ensemble porte-substrat 54 comportant une partie plane 56 ou plateau, en forme de disque, disposé perpendiculaire à l'axe 18 de l'enceinte et centré sur cet axe. Cette partie plane est destinée à recevoir le substrat 57 à traiter.

Avantageusement, le plateau 56 de l'ensemble porte-substrat est partiellement ou totalement métallique et connecté à l'une des bornes d'un générateur radio ou basse fréquence 58 via une boîte d'accod 59. L'autre borne du générateur 58 est connectée à la masse.

Le plateau métallique 56 est supporté par un isolant électrique et/ou thermique 60 monté, dans le cas où le plateau 56 est polarisé, sur une embase 62 métallique, connectée à la masse. Ce système permet une polarisation radio ou basse fréquence du substrat 57 à traiter, placé au contact du plateau métallique 56. Par ailleurs, le chauffage du substrat 57 peut être assuré par des moyens classiques non représentés. Pour ce faire, le plateau 56 doit être réalisé en un matériau bon conducteur de la chaleur et de l'électricité dans le cas où il est polarisé et en particulier en inox.

Afin d'éviter les effets de bord et d'assurer un dépôt homogène sur toute la surface du substrat, il est souhaitable qur la plaque perforée 40 ait un diamètre supérieur à celui du plateau 56 du porte-substrat (ou de l'ensemble des porte-substrats lorsqu'il y en a plusieurs).

L'embase 62 de l'ensemble porte-substrat est montée sur une plaque circulaire 64 fermant hermétiquement l'extrémité inférieure de l'enceinte de traitement. Cette plaque 64 est équipée de fenêtres 66 distribuées selon un cercle, centré sur l'axe 18. La plaque 64 est perpendiculaire à l'axe 18.

Ces ouvertures 66 en arc de cercle assurent la mise en communication de l'enceinte de traitement 12 avec le système de pompage 16 et permettent un pompage annulaire et périphérique de l'enceinte de traitement, selon une direction axiale.

La distance D1 séparant le plateau 56 du porte-substrat et la plaque 40 de diffusion du plasma, la distance D2 séparant la plaque de diffusion 40 de la plaque obstacle 30, la distance D3 séparant cette dernière du couvercle 14 de l'enceinte et la distance D4 séparant le couvercle 14 du guide hyperfréquence 26 sont à ajuster expérimentalement en fonction de la nature du traitement que l'on veut effectuer.

Dans le mode de réalisation représenté sur la figure 2 l'enveloppe cylindrique 34, la plaque obstacle 30 et la plaque diffuseur 40 sont réalisées en quartz ou en inox. Par ailleurs, le guide 26 est de façon classique en métal, la cellule 28 et le conduit d'alimentation en gaz 20 sont par exemple en quartz tandis que le conduit 38 peut être en inox.

Si l'on désire polariser les tubes 50 d'alimentation en gaz vecteur à l'aide d'une source 68 basse fréquence ou radio fréquence (figure 1), via une boîte d'accord 69, il est nécessaire d'utiliser des tubes isolants électriques 70, comme représenté sur la figure 4, pour supporter l'enveloppe torique 49 et isoler ainsi l'enceinte 12 portée à la masse des tubes 50 polarisés (l'enveloppe 49 et les tubes 50 étant réalisés en un matériau conducteur tel que l'inox). En plus de cette isolation électrique, ces tubes 70 assurent la mise en communication du tube 38 d'alimentation en gaz vecteur avec la chambre torique.

L'isolant électrique peut être du quartz ou de l'alumine. La puissance basse fréquence ou radio fréquence issue de la source 68 est alors amenée par l'intermédiaire d'un passage électrique étanche (non représenté) sur l'enveloppe métallique 49 définissant la chambre tampon torique. L'autre borne de la source 68 est reliée à la masse.

Dans ces conditions, tout le système d'injection du gaz vecteur (paroi 49 et tubes 50) est polarisé.

Il est aussi possible, comme représenté sur la figure 5, de n'assurer qu'une polarisation de l'extrémité de sortie des tubes d'alimentation 50. Pour ce faire, on enrobe l'enveloppe 49 et les tubes d'alimentation 50 qui sont en un matériau conducteur tel que l'inox d'un matériau isolant 72 (en silice ou en alumine) que l'on recouvre d'un matériau conducteur 74 en aluminium ou en silicium. On obtient ainsi une structure coaxiale dont l'âme (paroi 49 et tubes 50) peut être polarisée. A cet effet, la borne basse fréquence ou radio fréquence de la source 68 est, via la boîte d'accord 69, connectée aux tubes métalliques 50 et à l'enveloppe 49 de la chambre torique et leur revêtement 74 est relié à la masse.

On aurait pu également connecter à la masse les tubes 50 et l'enveloppe 49 et à la borne basse fréquence ou radio-fréquence, le revêtement 74.

Dans ce cas, on polarise l'ensemble du revêtement 74.

Le dispositif conforme à l'invention a été utilisé pour déposer de l'oxyde de silicium (SiOₓ avec x de l'ordre de 2) à grande vitesse et en particulier de 1 »m par minute et de façon homogène, sur des substrats de 10 cm de diamètre (4 pouces).

Les distances D1, D2, D3 et D4 valaient respectivement 30 mm, 10 mm, 15 mm et 10 mm. Le nombre de tubes 50 d'alimentation en gaz vecteur était de 37 : 23 de ces tubes débouchant dans l'enceinte sur un cercle 55 de 100 mm de diamètre centré sur l'axe 18, 10 de ces tubes débouchant sur un cercle 53 de 70 mm de diamètre centré sur l'axe 18 et 4 de ces tubes débouchant sur un cercle 51 de 30 mm de diamètre centré sur l'axe 18. Ces tubes avaient un diamètre intérieur de 1 mm.

La plaque perforée 40 comportait un ensemble de trous de 2 mm de diamètre dont 8 trous étaient disposés sur un cercle de 30 mm de diamètre centré sur l'axe 18, 8 autres trous étaient disposés sur un cercle de 50 mm de diamètre centré sur l'axe, 16 autres trous étaient répartis selon un cercle de 70 mm de diamètre centré sur l'axe, 24 autres trous étaient répartis sur un diamètre de 90 mm centré sur l'axe et 32 autres trous étaient répartis sur un cercle de 110 mm de diamètre centré sur l'axe.

Le diamètre interne de la chambre 32 était de 120 mm, le diamètre de la plaque obstacle 30 était de 100 mm et le diamètre interne de l'enceinte de dépôt 12 était de 248 mm.

Le dépôt de SiOₓ a été effectué dans les conditions suivantes :
- puissance fournie par le générateur HF 24 de la source à plasma : 400 W,
- puissance réfléchie par ce générateur HF : 0 W
- gaz porteur ionisé : N₂O avec un débit de 275 sccm (standard centimètre cube par minute)
- gaz vecteur non ionisé : SiH₄ à un débit de 70 sccm,
- pression : 14,6 Pa (110 mtorr),
- température ; 400°C contrôlés sur le plateau du porte-substrat à l'aide d'un thermocouple.

Dans ces conditions, on a obtenu un dépôt de SiO₂ de bonne qualité, dite qualité microélectroni-que, avec une bonne adhérence et un indice de réfraction optique moyen de 1,46. L'uniformité du dépôt était de 3%, les contraintes en compression étaient de 2,5.10⁴ N/cm² ; une gravure chimique de cet oxyde avec une solution d'acide fluorhydrique à 10% tamponné par du fluorure d'ammonium dans de l'eau désionisée était 6 fois plus rapide que celle d'un oxyde thermique de référence. La densité de ce dépôt était de 2,3 g/cm².

Le dispositif de l'invention décrit précédemment peut, bien entendu, aussi être utilisé pour faire du nettoyage chimique de substrats ou pour graver de façon anisotrope ou isotrope ces substrats.

## Revendications

1. Dispositif de traitement chimique assisté par un plasma de diffusion comportant :
- une enceinte étanche de traitement (12) comportant un axe de symétrie (18),
- des moyens (20, 22) de production axiale d'un plasma d'un gaz porteur dans l'enceinte,
- au moins une plaque pleine (30) servant d'obstacle au plasma, disposée perpendiculairement à l'axe (18) et en aval des moyens de production,
- des moyens de diffusion du plasma (40), disposés dans l'enceinte en aval de la plaque (30),
- plusieurs tubes (50) d'alimentation en gaz vecteur non ionisé débouchant axialement dans l'enceinte, sous les moyens de diffusion (40), les extrémités (52) de ces tubes débouchant dans l'enceinte étant situées dans un même plan tout autour de l'axe de l'enceinte,
- au moins un porte-substrat (56) disposé dans l'enceinte en aval des tubes d'alimentation et perpendiculairement à l'axe de l'enceinte,
- des moyens de pompage (16, 64, 66) annulaire et axial du milieu gazeux contenu dans l'enceinte, disposés en aval du porte-substrat.

2. Dispositif selon la revendication 1, caractérisé en ce qu'il comprend en outre une chambre tampon périphérique (48), entourant l'axe (18), communiquant avec les tubes d'alimentation (50) et des moyens d'alimentation (38) en gaz vecteur de cette chambre tampon.

3. Dispositif selon la revendication 2, caractérisé en ce que la chambre tampon (48) est torique.

4. Dispositif selon l'une quelconque des revendications 1 à 3, caractérisé en ce que lesdites extrémités (52) des tubes sont disposées selon des cercles concentriques centrés sur l'axe de l'enceinte.

5. Dispositif selon l'une quelconque des revendications 1 à 4, caractérisé en ce que les tubes (50) sont réalisés en un matériau conducteur de l'électricité, leur paroi externe étant alors revêtue d'un matériau isolant électrique (72) puis d'un matériau conducteur (74).

6. Dispositif selon la revendication 5, caractérisé en ce que des moyens de polarisation (68) des tubes (50) ou du matériau conducteur (74) sont prévus.

7. Dispositif selon l'une quelconque des revendications 1 à 6, caractérisé en ce qu'il comprend en outre une chambre tampon (32) fermée par une plaque perforée (40) constituant les moyens de diffusion du plasma, cette chambre (32) communiquant avec les moyens (20, 22) de production du plasma, la plaque obstacle contenue dans cette chambre définissant avec cette dernière un espace périphérique (42) pour le passage du plasma.

8. Dispositif selon l'une quelconque des revendications 1 à 7, caractérisé en ce que les moyens de production (20, 22) du plasma comprennent une alimentation axiale (20) en gaz porteur couplée à des moyens (22) d'excitation du gaz porteur.

9. Dispositif selon l'une quelconque des revendications 1 à 8, caractérisé en ce que les moyens de production du plasma comprennent un surfaguide (22).

10. Dispositif selon l'une quelconque des revendications 1 à 9, caractérisé en ce que des moyens de polarisation (59) et/ou de chauffage du porte-substrat sont prévus.

11. Dispositif selon l'une quelconque des revendications 6 à 10, caractérisé en ce que la plaque perforée (40) présente des dimensions supérieures à celles du porte-substrat (56) ou de l'ensemble des porte-substrats.

## Patentansprüche

1. Gerät für chemische Behandlung mit Hilfe eines Diffusionsplasmas, umfassend:
- einen dichten Behandlungsbehälter (12) mit einer Symetrieachse (18),
- Einrichtungen (20, 22) zur axialen Erzeugung eines Plasmas eines Trägergases in dem Behälter,
- wenigstens eine Vollplatte (30), die als Hindernis für das Plasma dient, senkrecht zur Achse (18) angeordnet und flußabwärts von den Erzeugungseinrichtungen,
- Plasma-Diffusionseinrichtungen (40), in dem Behälter flußabwärts von der Platte (30) angeordnet,
- mehrere Rohre (50) zur Versorgung mit nichtionisiertem Schlepp- bzw. Traggas, axial in den Behälter mündend, unter den Diffusionseinrichtungen (40), wobei die Enden (52) dieser in den Behälter mündenden Rohre sich in ein und derselben Ebene befinden, um die Achse des Behälters herum,
- wenigstens einen Substratträger (56), in dem Behälter flußabwärts von den Versorgungsrohren und senkrecht zur Achse des Behälters angeordnet,
- ringförmige und axiale Pumpeinrichtungen (16, 64, 66) des in dem Behälter befindlichen gasförmigen Mediums, angeordnet flußabwärts von dem Substratträger.

2. Gerät nach Anspruch 1, dadurch gekennzeichnet, daß es außerdem eine periphere Pufferkammer (48) umfaßt, um die Achse (18) herum, verbunden mit den Traggas-Versorgungsrohren (50) und -Versorgungseinrichtungen (38) dieser Pufferkammer.

3. Gerät nach Anspruch 2, dadurch gekennzeichnet, daß die Pufferkammer (48) torisch ist.

4. Gerät nach einem der Ansprüche 1 bis 3, dadurch gekennzeichnet, daß die genannten Enden (52) der Rohre konzentrischen Kreisen entsprechend angeordnet sind, zentriert auf die Achse des Behälters.

5. Gerät nach einem der Ansprüche 1 bis 4, dadurch gekennzeichnet, daß die Rohre (50) aus einem elektrisch leitenden Material hergestellt sind, wobei ihre Außenwand dann mit einem elektrisch isolierenden Material (72) beschichtet ist, danach mit einem leitenden Material (74).

6. Gerät nach Anspruch 5, dadurch gekennzeichnet, daß Vorspannungseinrichtungen (68) der Rohre (50) oder des leitenden Materials (74) vorgesehen sind.

7. Gerät nach einem der Ansprüche 1 bis 6, dadurch gekennzeichnet, daß es außerdem eine durch eine perforierte Platte (40) verschlossene Pufferkammer (32) umfaßt, die Diffusionseinrichtungen des Plasmas bildend, wobei diese Kammer (32) verbunden ist mit den Plasmaerzeugungseinrichtungen (20, 22) und die in dieser Kammer enthaltene Hindernisplatte mit letzterer einen peripheren Raum (42) für den Durchlaß des Plasmas bildet.

8. Gerät nach einem der Ansprüche 1 bis 7, dadurch gekennzeichnet, daß die Plasmaerzeugungseinrichtungen (20, 22) eine Axialversorgung (20) mit Trägergas umfassen, gekoppelt mit Trägergas-Erregungseinrichtungen (22).

9. Gerät nach einem der Ansprüche 1 bis 8, dadurch gekennzeichnet, daß die Plasmaversorgungseinrichtungen eine Oberflächenleitervorrichtung (un surfaguide) (22) umfassen.

10. Gerät nach einem der Ansprüche 1 bis 9, dadurch gekennzeichnet, daß Einrichtungen (59) zum Vorspannen und/oder Heizen des Substratträgers vorgesehen sind.

11. Gerät nach einem der Ansprüche 1 bis 10, dadurch gekennzeichnet, daß die perforierte Platte (40) Abmessungen aufweist, die größer sind als die der Substratträger (56) oder die Gesamtheit der Substratträger.

## Claims

1. Diffusion plasma-assisted chemical treatment apparatus incorporating a tight treatment enclosure (12) having an axis of symmetry (18), axial production means (20, 22) for a plasma of a carrier gas in the enclosure, at least one solid plate (30) serving as an obstacle to the plasma and positioned perpendicular to the axis (18) and downstream of the production means, plasma diffusion means (40) located downstream of the plate (30) in the enclosure, several non-ionized vector gas supply tubes (50) issuing axially into the enclosure, beneath the diffusion means (40), the ends (52) of said tubes issuing into the enclosure being in the same plane around the enclosure axis, at least one substrate carrier (56) located in the enclosure downstream of the supply tubes and perpendicular to the enclosure axis and annular, axial pumping means (16, 64, 66) for the gaseous medium contained in the enclosure and positioned downstream of the substrate carrier.

2. Apparatus according to claim 1, characterized in that it also comprises a peripheral buffer chamber (48) surrounding the axis (18) and linked with the supply tubes (50) and the vector gas supply means (38) for said buffer chamber.

3. Apparatus according to claim 2, characterized in that the buffer chamber (48) is toroidal.

4. Apparatus according to any one of the claims 1 to 3, characterized in that the tube ends (52) are arranged according to concentric circles centred on the enclosure axis.

5. Apparatus according to any one of the claims 1 to 4, characterized in that the tubes (50) are made from an electricity conducting material, their outer wall then being coated with an electrically insulating material (72) and then a conductive material (74).

6. Apparatus according to claim 5, characterized in that polarization means (68) for the tubes (50) or the conductive material (74) are provided.

7. Apparatus according to any one of the claims 1 to 6, characterized in that it also comprises a buffer chamber (32) sealed by a perforated plate (40) constituting the plasma diffusion means, said chamber (32) communicating with the plasma production means (20, 22), the obstacle plate contained in said chamber defining with the latter a peripheral space (42) for the passage of the plasma.

8. Apparatus according to any one of the claims 1 to 7, characterized in that the plasma production means (20, 22) comprise an axial carrier gas supply (20) coupled to carrier gas exciting means (22).

9. Apparatus according to any one of the claims 1 to 8, characterized in that the plasma production means comprise a surfaguide (22).

10. Apparatus according to any one of the claims 1 to 9, characterized in that substrate carrier heating and/or polarization means (59) are provided.

11. Apparatus according to any one of the claims 6 to 10, characterized in that the perforated plate (40) has dimensions greater than those of the substrate carrier (56) or the substrate carrier assembly.
